# EUROPEAN PATENT SPECIFICATION

(11) **EP 1 914 421 B1**
(45) Date of publication and mention of the grant of the patent: **03.12.2008**
(21) Application number: 06425714.0
(22) Date of filing: 18.10.2006
(51) Int. Cl.: F03G 7/06, G01S 3/786, F24J 2/38, F24J 2/07

(54) **Shape memory actuator device for imparting a sun tracking movement to an orientable member, in particular a solar generator**
Aktuator mit Formgedächtnislegierung in einer Sonnenverfolgungseinrichtung, insbesondere einem Sonnenkollektor
Dispositif de poursuite du soleil, en particulier un générateur solaire, avec actionneur en alliage à mémoire de forme

(43) Date of publication of application: 23.04.2008
(73) Proprietor: C.R.F. Società Consortile per Azioni, 10043 - Orbassano (Torino) (IT)
(72) Inventor: Alacqua, Stefano, 10043 Orbassano (Torino) (IT); Biasiotto, Marco, 10043 Orbassano (Torino) (IT); Capretti, Gianluca, 10043 Orbassano (Torino) (IT); Perosino, Andrea, 10043 Orbassano (Torino) (IT)
(74) Representative: Notaro, Giancarlo

(56) References cited:
- WO-A-99/61792
- JP-A- 59 119 144
- JP-A- 60 205 151
- US-B1- 6 298 662

## Description

The present invention relates to devices designed to impart a sun-tracking movement on an orientable member, in particular a solar generator, of the type comprising at least one shape-memory element activated by the heat generated by solar radiation.

A device of the type referred to above is, for example, known from the document No. JP-A-11125765. A device as set forth in the preamble of claim 1 is known from JP 59 119 144 A.

The purpose of the present invention is to provide a device of the type specified above that will be particularly simple and efficient in operation.

With a view to achieving said purpose, the subject of the invention is an actuator device having the characteristics of claim 1.

The invention will now be described with reference to the annexed plate of drawings, which is provided purely by of non-limiting example and in which:

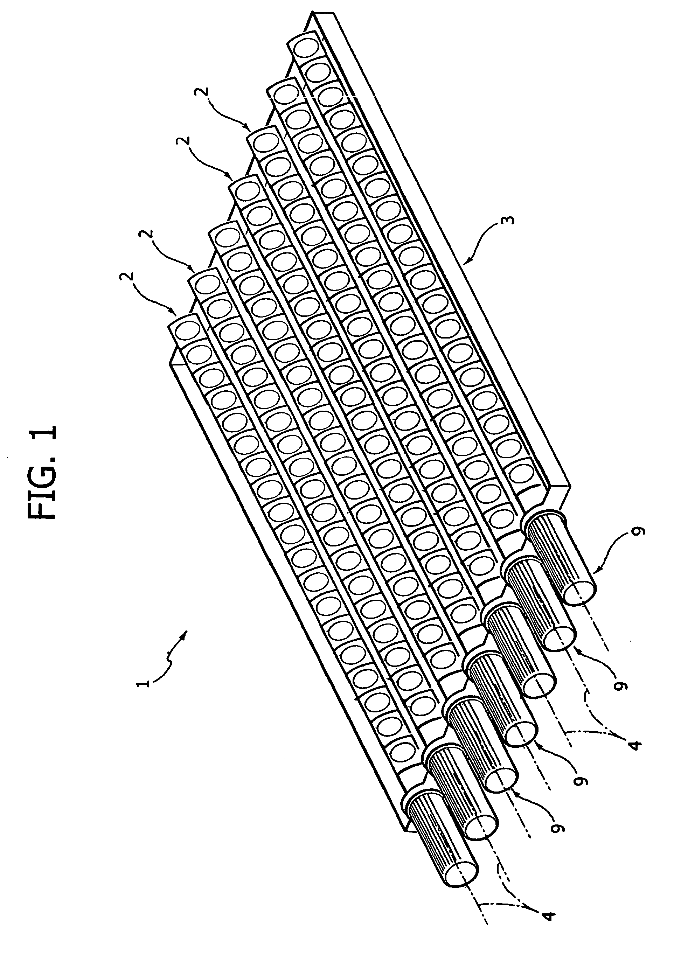

- Figure 1 is a perspective view of a solar converter unit provided with a plurality of actuator devices according to the invention;
- Figures 2A, 2B, 2C are schematic cross-sectional views that show three different positions assumed by the modules constituting the unit of Figure 1, as the position of the sun varies;
- Figures 3-5 are, respectively, an exploded perspective view, a partially sectioned perspective view, and a schematic cross-sectional view of an actuator device according to the invention;
- Figure 6 is a further perspective view of the actuator device according to the invention; and
- Figures 7A, 7B, 7C are cross-sectional views of the actuator device, which show different modes of heating of the shape-memory element.

In the plate of drawings, the reference number 1 designates as a whole a photovoltaic panel constituted by a series of photovoltaic modules 2 set parallel to one another and alongside one another, which are mounted so that they can turn within a supporting frame 3 about respective axes of articulation 4 parallel to one another.

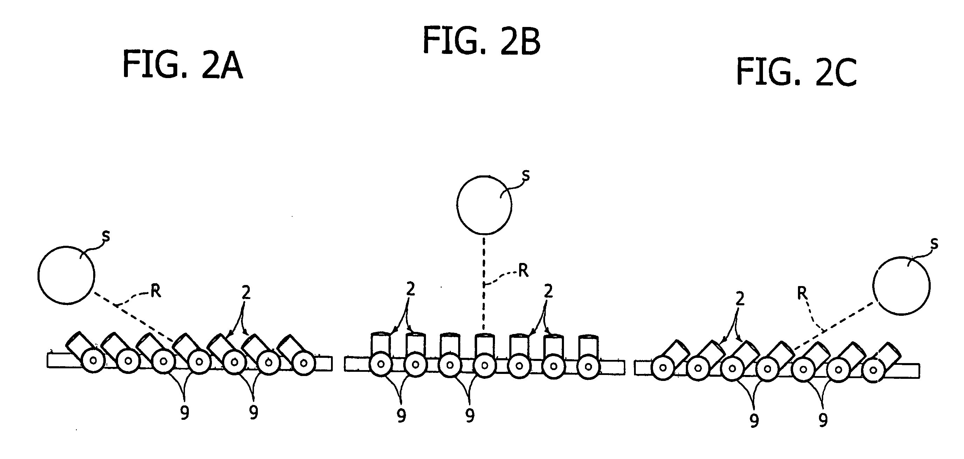

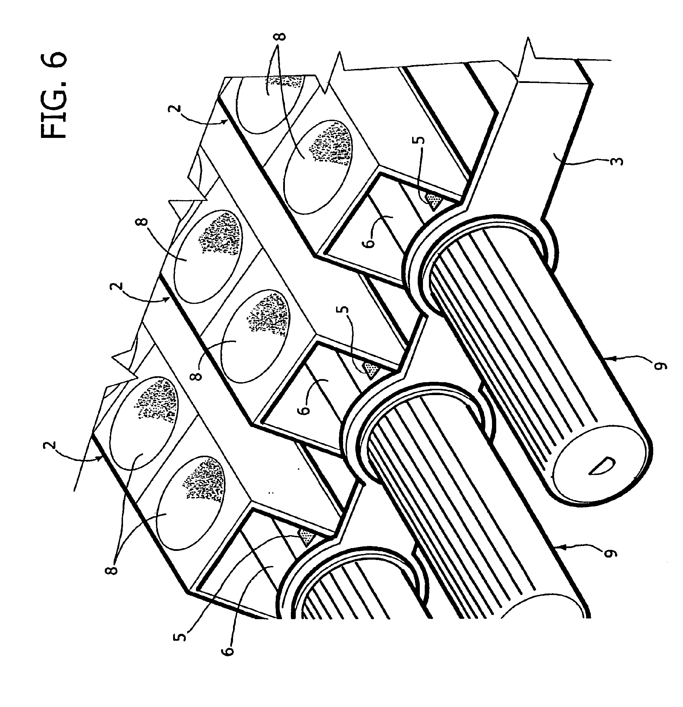

As may be seen in particular in Figure 6, each module 2 comprises an aligned series of photovoltaic cells 5 mounted on an elongated plate 6 having its two opposite ends supported in an articulated way by two opposite sides of the frame 3 about the respective axis of articulation 4. The plate 6 in turn supports a substantially channel-shaped covering structure, bearing on its top surface a distribution of concentric lenses 8 each associated to a respective photovoltaic cell 5. As will emerge clearly from the ensuing description, as the position of the sun varies (see also Figures 2A, 2B, and 2C) each module 2 is oriented about the respective axis of articulation 4 so as to track the sun. In particular, the movement obtained is such that for each position of the sun the plane of each plate 6 bearing the photovoltaic cells 5 remains substantially orthogonal to the direction of the direct solar radiation, designated by R in Figures 2A-2C. In the example illustrated, the axes of articulation 4 of the modules 2 are oriented substantially in a north - south direction so as to enable the modules 2 to track the daily motion of the sun. It is, however, possible to envisage also an orientation of the entire frame 3 to enable tracking also of the seasonal movement of the sun.

In order to obtain the sun-tracking movement of each module 2, associated to each module 2 is an actuator device 9 according to the present invention. Of course, it is also possible to envisage a single actuator member 9 that will control directly the tracking movement of one of the modules 3, and then to provide a transmission, for example of the pantograph type, for connection between the module 2, which is controlled directly by the actuator device, and the remaining modules 2, in such a way as to force the latter to perform a movement identical to that of the module 2 controlled by the actuator device.

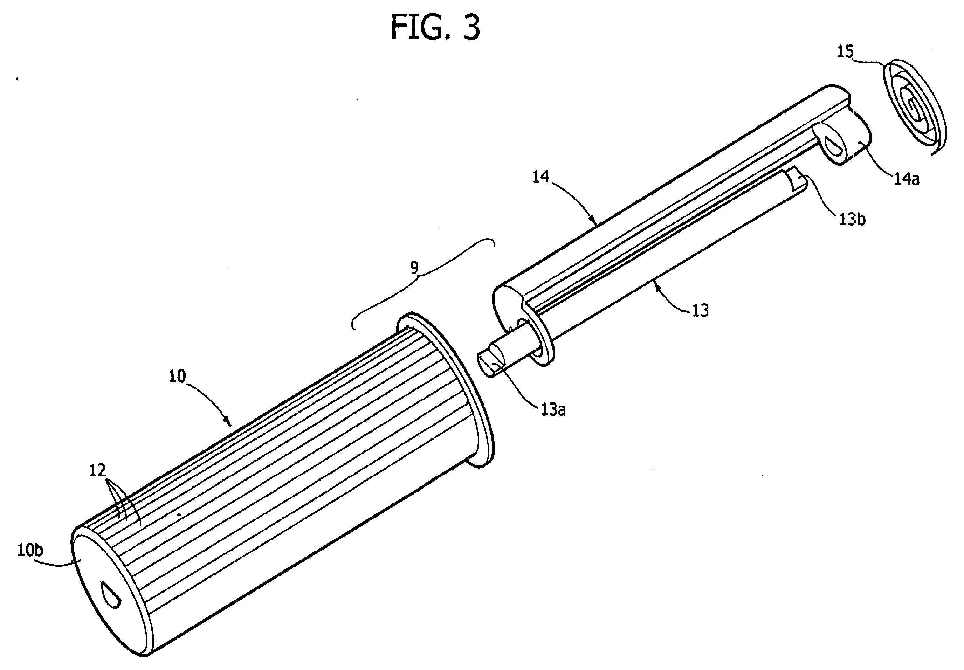

With reference in particular to Figures 3-5, each actuator device 9 comprises a cylindrical body 10 functioning as solar collector rigidly mounted in cantilever fashion on the frame 3, with an end flange 10a thereof fixed to said frame. One sector 11 of the wall of the collector 10, corresponding to an angular range A that is sufficiently wide as to cover the entire arc of movement of the sun, is made of transparent material, for example of transparent plastic material, and has its outer surface shaped so as to define a plurality of lenses 12 shaped and sized in such a way that for each position of the sun only one of said lenses 12 is able to concentrate the direct solar radiation R on a shape-memory element 13 set at the centre of the collector 10.

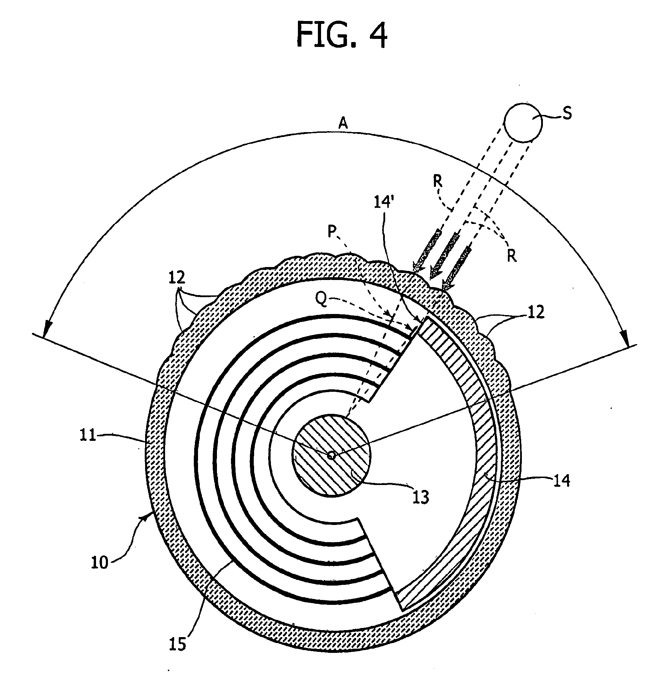

The shape-memory element 13 is constituted by a torsion bar having one end 13a rigidly connected to a bottom wall 10b of the wall of the collector 10, and is consequently fixed in position. The opposite end 13b of the bar is instead connected in rotation to a tubular appendage 14a projecting from one end of an elongated shield 14 shaped like the sector of a cylindrical wall and set concentrically within the collector 10 (see, in particular, Figure 4). The cylindrical wall of the shield 14 is made of any material, for example, of plastic material, that is not transparent or in any case such as to intercept solar radiation. A spiral spring 15 is set between the collector member 10 and the shield 14 so as to recall the latter towards an end-of-travel position in which the shield is in a position totally lying outside the angular range A. With reference to Figure 4, if the movement of the sun in said figure is in the counterclockwise direction, the return spring 15 is pre-arranged for pushing the shutter 14 in a clockwise direction from the position in which it is represented in said figure towards a position set at the right with respect to the sector A.

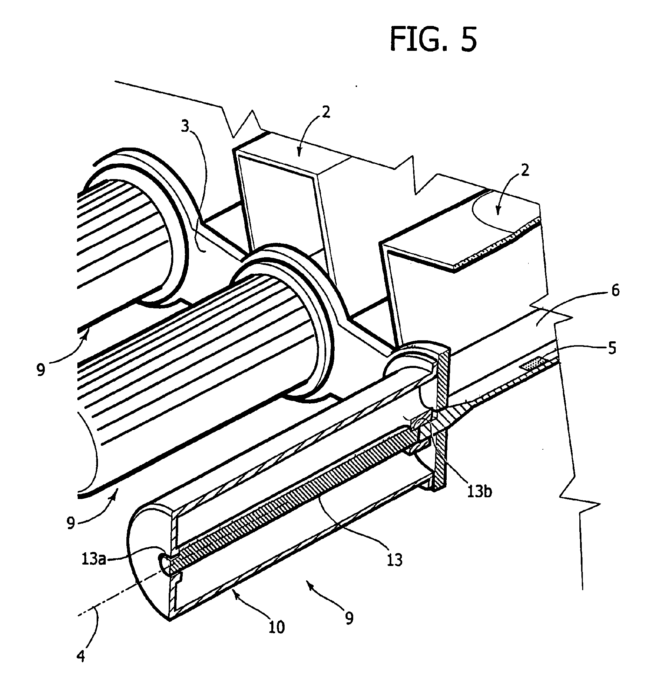

The structure of the shield 14 is in turn connected in rotation to the structure of the respective module 2 (see Figure 5).

As has already been mentioned above, the shape-memory actuator element 13 is a torsion bar made of any shape-memory material chosen in such a way that, as the temperature increases above a transition value characteristic of the shape-memory element, the end 13b of the torsion bar rotates with respect to the end 13a anchored via the collector 10 to the structure of the frame 3. For each position of the sun S in the course of the day, the direct radiation R is focused by a respective lens 12 of the collector 10 on the torsion bar 13, which is found in a position that coincides with the axis of the cylindrical wall of the collector 10. The arrangement is such that the light focused on the shape-memory actuator element causes an increase in temperature thereof above the transition value. The shape-memory element is pre-arranged in such a way that the rotation of the end 13b that occurs when the shape-memory element passes from a martensitic structure to an austenitic structure following upon overstepping of the transition value is potentially sufficient for bringing about a rotation of the shield 14 from its resting position as far as a position in which it comes to cover with its end edge 14', which faces forwards with reference to the direction of rotation, the last cylindrical lens 12 set at the end of the angular range A furthest away with respect to the resting position of the shield (i.e., the lens 12 illustrated furthest to the left in Figure 4). Assuming that the sun is in the position S illustrated in Figure 4, the actual rotation of the shield 14 caused by activation of the shape-memory element 13 does not proceed as far as the final position described above and stops, instead, when the shield 14 intercepts the lens 12, which in said moment is focusing the direct radiation R coming from the sun on the shape-memory element. This occurs substantially when the edge 14' of the shield 14 (see Figure 4) comes to correspond to the radial plane designated by P in Figure 4. In said condition, the direct radiation R is no longer focused on the shape-memory actuator element 13, which consequently cools down to resume its resting condition. The shield 14 thus tends to rotate in a clockwise direction (as viewed in Figure 4) returning to its resting position, under the thrust of the return spring 15. However, as soon as the shield has returned into the position that is illustrated in Figure 4, aligned with the radial plane designated by Q in Figure 4, the lens 12' is once again able to focus the solar radiation on the shape-memory element so that the latter exceeds once again its transition temperature and again brings about a counterclockwise rotation of the shield 14. The phenomenon described above repeats cyclically, with successive oscillations of the shield 14 between the angular position P and the angular position Q. Basically then, the shield is kept on average in a position in which its edge 14' is aligned with the solar radiation R. Since, as has been seen, the structure of the shield 14 is connected in rotation to the structure of the respective module 2, also the module 2 will perform the same movements of oscillation maintaining itself on average aligned with the sun. The arrangement is, in fact, such that, when the edge 14' of the shield 14 is found in an angular position intermediate between the radial planes P and Q, the plane of the photovoltaic cells of the module 2 is substantially orthogonal to the direct radiation R.

As the position of the sun varies, the shield will consequently continue to maintain the plane of the photovoltaic cells 5 of the respective module 2 substantially orthogonal to the direction of the sun, at the same time continuing to perform minor oscillations about said position.

The collector 10 and the shape-memory material are designed so as to guarantee proper operation even with low values of solar radiation, for example, in the region of 200 W/m². The excess of available energy in conditions of higher values of solar radiation, for example, in the region of 1000 W/m², will not damage the actuator in so far as it is intrinsically protected by the movement of the shield 14.

In addition, on the surface of the collector 10 hatches can be provided, in turn controlled by shape-memory elements, that will enable an automatic change of air should the temperature within the collector overstep the conditions of proper operation.

Of course, even though the example illustrated makes use of a shape-memory actuator element constituted by a torsion bar, it is also possible to envisage a shape-memory actuator element constituted, for instance, by a linearly mobile element, for example, a wire that reduces its length when it is activated, in which case mechanisms of transmission must be envisaged for converting the linear motion of the shape-memory actuator into a rotation of the shield 14 (for example, a rack-and-pinion transmission).

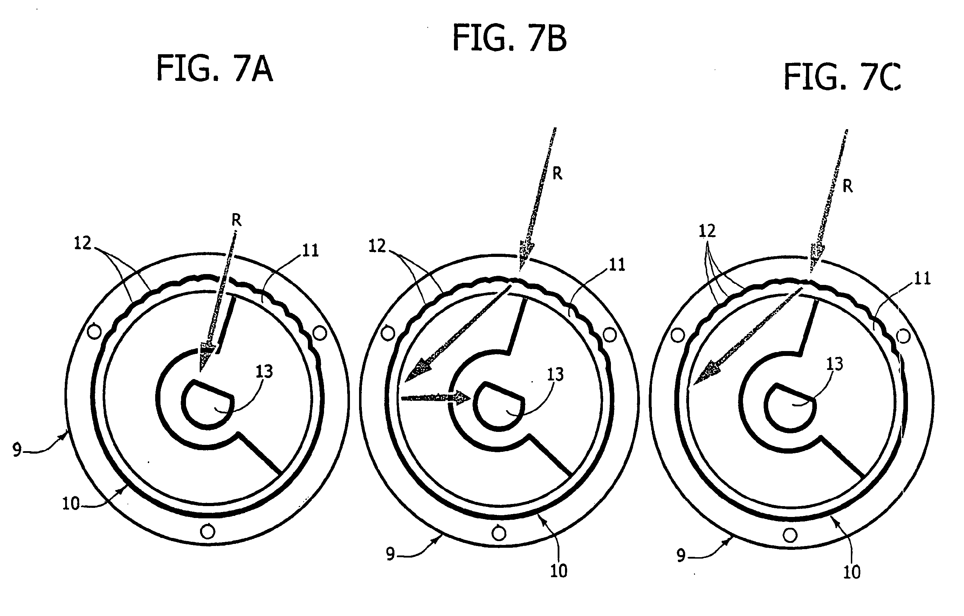

With reference once again to Figures 7A, 7B and 7C, heating of the shape-memory actuator 13 can be obtained either by focusing the direct solar radiation (Figure 7A) or by focusing the direct solar radiation and then reflecting it within the collector (Figure 7B), or else indirectly, by focusing the direct solar radiation on the wall of the collector, which functions as black body and determines an increase in the temperature of its internal environment.

By combining two trackers on two orthogonal axes of the panel it is possible to track the sun both on a daily basis and on a seasonal basis. One of the two tracking modules may not be of the type forming subject of the present invention. For example, it is possible to envisage a tracking module that operates on a daily basis according to the invention and a tracking module that operates on a seasonal basis controlled by an electric motor.

In addition, the collector 10 can be made with techniques in themselves known in the field of solar collectors, for example in the form of a double tube, or with vacuum gap, or else using special glasses in order to reduce the losses of heat and increase efficiency of the collector.

Of course, without prejudice to the principle of the invention, the details of construction and the embodiments may vary widely with respect to what is described and illustrated herein as defined in the appended claims.

## Claims

1. A shape-memory actuator device for imparting a sun-tracking movement on an orientable member (2), which is rotatable around an articulation axis (4), said device comprising at least one shape-memory element (13) activated by the heat generated by the solar radiation,
wherein the shape-memory element (13) is surrounded by a distribution of lenses (12) designed to focus always, as the position of the sun varies, the direct solar radiation on the shape-memory element (13), said device further comprising a sun-shielding member (14), connected in rotation to the orientable member (2) and controlled by the shape-memory element (13) in such a way that it is moved, as a result of activation of the shape-memory element (13) due to the solar radiation, as far as a position in which it shields the shape-memory element with respect to the direct solar radiation, with consequent de-activation of the shape-memory element (13) and return of the shielding member (14) into a position in which it uncovers again the shape-memory element (13) with respect to the direct solar radiation, thus determining re-activation of the shape-memory element, with the result that the shielding member (14) oscillates continuously about a position that corresponds to a desired alignment of the orientable member with the sun and that follows the sun in its path,
**characterized in that** the aforesaid distribution of lenses (12) is defined on an angular sector (A) of the wall of a cylindrical collector (10) concentric with said articulation axis (4), and that the shape-memory element (13) is set inside said cylindrical collector, and
**in that** the shielding member (14) comprises a cylindrical wall that is concentric with the cylindrical wall of the collector (10).

2. The actuator device according to Claim 1, **characterized in that** means (15) are provided for recalling the shielding member (14) to an end-of-travel position.

3. The actuator device according to Claim 2, **characterized in that** said recalling means are constituted by a spring (15).

4. The actuator device according to Claim 1, **characterized in that** the shape-memory element (13) is in the form of a torsion bar, with one end (13a) anchored to the body of the collector (10) and the opposite end (13b) connected in rotation to the aforesaid shielding member (14).

5. The actuator device according to Claim 1, **characterized in that** said cylindrical wall of the shielding member (14) is set inside the cylindrical wall of the collector (10).

6. The actuator device according to Claim 5, **characterized in that** the body of the collector (10) is fixed to a frame (3), on which the aforesaid orientable member (2) is rotatably mounted and **in that** said shielding member (14) is connected in rotation to said orientable member (2).

7. The actuator device according to any one of the preceding claims, **characterized in that** said orientable member is constituted by a photovoltaic module (2) comprising an elongated wall (6) having its opposite ends supported in an articulated way on a frame (3) and carrying thereon an aligned distribution of photovoltaic cells (5), said elongated plate (6) supporting in turn a covering structure including a distribution of focusing lenses (8), each of which is associated to a photovoltaic cell (5) for concentrating on the latter the solar radiation, the arrangement being such that the aforesaid actuator device constantly maintains the shielding member (14) in a position that corresponds to a position of the aforesaid plate (6) carrying the photovoltaic cells (5) orthogonal to the direct radiation (R) of the sun.

8. The actuator device according to Claim 1, **characterized in that** the wall of the collector has openings controlled by hatches, which can open automatically to set in communication the internal environment of the collector with the external environment when the temperature within of the collector exceeds a pre-set value.

9. The actuator device according to Claim 8, **characterized in that** said hatches are controlled by shape-memory actuator means sensitive to the temperature inside the collector.

10. The actuator device according to Claim 1, **characterized in that** said shape-memory actuator element (13) is constituted by an elongated element, which decreases in length as a transition temperature is exceeded, and **in that** a mechanical transmission is provided designed to convert the linear movement of the shape-memory element into a rotary movement of the aforesaid shielding member.

11. A device according to Claim 1, **characterized in that** the aforesaid collector (10) is pre-arranged for heating the shape-memory element (13) by direct focusing of the solar radiation via said lenses (12) set on top of the shape-memory element (13), or else by focusing of the direct radiation of the sun on the internal wall of the collector (10), which functions as black body designed to increase its internal temperature.

12. The device according to Claim 1, **characterized in that** the aforesaid collector (10) is pre-arranged for heating the shape-memory element (13) via said lenses (12), directing the direct radiation of the sun on a portion of the internal surface of the collector, said surface being reflective and focusing on the shape-memory element (13).

## Patentansprüche

1. Formgedächtnisaktorvorrichtung zum Übermitteln einer Sonnenverfolgungsbewegung auf ein verstellbares Element (2), das um eine Gelenkachse (4) drehbar ist, wobei die Vorrichtung wenigstens ein Formgedächtniselement (13) umfasst, das durch die von der Sonneneinstrahlung erzeugte Wärme aktiviert wird,
wobei das Formgedächtniselement (13) von einer Verteilung von Linsen (12) umgeben ist, die ausgelegt ist, um sich ständig, während sich die Position der Sonne ändert, auf die direkte Sonneneinstrahlung auf das Formgedächtniselement (13) zu richten, wobei die Vorrichtung des Weiteren ein Sonnen-Abschirmungselement (14) umfasst, das mit dem verstellbaren Element (2) drehverbunden ist und von dem Formgedächtniselement (13) in einer solchen Art und Weise gesteuert wird, dass es im Ergebnis der Aktivierung des Formgedächtniselementes (13) auf Grund der Sonneneinstrahlung bis zu einer Position bewegt wird, in der es das Formgedächtniselement in Bezug auf die direkte Sonneneinstrahlung abschirmt, mit daraus folgender Deaktivierung des Formgedächtniselementes (13) und Rückkehr des Abschirmungselementes (14) in eine Position, in der es das Formgedächtniselement (13) in Bezug auf die direkte Sonneneinstrahlung wieder freilegt und infolgedessen Reaktivierung des Formgedächtniselementes veranlasst, mit dem Ergebnis, dass das Abschirmungselement (14) kontinuierlich um eine Position oszilliert, die einer Soll-Ausrichtung des verstellbaren Elementes mit der Sonne entspricht und die der Sonne auf ihrer Bahn folgt,
und **dadurch gekennzeichnet, dass** die Verteilung von Linsen (12) auf einem Winkelsektor (A) der Wand eines zylindrischen Kollektors (10) konzentrisch mit der Gelenkachse (4) gebildet ist, dass das Formgedächtniselement (13) im Inneren des Kollektors eingerichtet ist und
dass das Abschirmungselement (14) eine zylindrische Wand umfasst, die konzentrisch mit der zylindrischen Wand des Kollektors (10) ist.

2. Aktorvorrichtung nach Anspruch 1, **dadurch gekennzeichnet, dass** Einrichtungen (15) zum Rückstellen des Abschirmungselementes (14) auf eine Endstellung bereitgestellt sind.

3. Aktorvorrichtung nach Anspruch 2, **dadurch gekennzeichnet, dass** die Rückstelleinrichtungen durch eine Feder (15) gebildet werden.

4. Aktorvorrichtung nach Anspruch 1, **dadurch gekennzeichnet, dass** das Formgedächtniselement (13) in Form eines Torsionsstabes ist, der mit einem Ende (13a) an dem Körper des Kollektors (10) verankert ist und mit dem gegenüberliegenden Ende (13b) in Drehverbindung mit dem Abschirmungselement (14) ist.

5. Aktorvorrichtung nach Anspruch 1, **dadurch gekennzeichnet, dass** die zylindrische Wand des Abschirmungselementes (14) im Inneren der zylindrischen Wand des Kollektors (10) eingerichtet ist.

6. Aktorvorrichtung nach Anspruch 5, **dadurch gekennzeichnet, dass** der Körper des Kollektors (10) an einem Rahmen (3) befestigt ist, auf dem das verstellbare Element (2) drehbar angebracht ist, und **dadurch**, dass das Abschirmungselement (14) mit dem verstellbaren Element (2) drehverbunden ist.

7. Aktorvorrichtung nach einem der vorherigen Ansprüche, **dadurch gekennzeichnet, dass** das verstellbare Element von einem photovoltaischen Modul (2) gebildet wird, das eine längliche Wand (6) umfasst, die mit ihren gegenüberliegenden Enden auf eine bewegliche Weise auf einen Rahmen (3) getragen wird und darauf eine ausgerichtete Verteilung photovoltaischer Zellen (5) trägt, wobei die längliche Platte (6) ihrerseits eine Abdeckungsstruktur trägt, die eine Verteilung von Fokussierungslinsen (8) enthält, von denen jede einer photovoltaischen Zelle (5) zugehörig ist, um die Sonneneinstrahlung auf die Letztere zu konzentrieren, und
wobei die Anordnung derartig ist, dass die Aktorvorrichtung das Abschirmungselement (14) konstant in einer Position vorhält, die einer Position der Platte (6) entspricht, die die photovoltaischen Zellen (5) senkrecht zu der direkten Einstrahlung (R) der Sonne trägt.

8. Aktorvorrichtung nach Anspruch 1, **dadurch gekennzeichnet, dass** die Wand des Kollektors Öffnungen aufweist, die durch Klappen geregelt werden, die sich automatisch öffnen können, um die Innenumgebung des Kollektors mit der Außenumgebung in Verbindung zu bringen, wenn die Temperatur innerhalb des Kollektors einen voreingestellten Wert übersteigt.

9. Aktorvorrichtung nach Anspruch 8, **dadurch gekennzeichnet, dass** die Klappen durch Formgedächtnisaktoreinrichtungen geregelt werden, die auf die Temperatur im Inneren des Kollektors ansprechen.

10. Aktorvorrichtung nach Anspruch 1, **dadurch gekennzeichnet, dass** das Formgedächtnisaktorelement (13) von einem länglichen Element gebildet wird, das sich in der Länge verringert, während eine Übergangstemperatur überschritten wird, und **dadurch**, dass eine mechanische Kraftübertragung so ausgelegt bereitgestellt ist, dass die Linearbewegung des Formgedächtniselementes in eine Drehbewegung des Abschirmungselementes umgewandelt wird.

11. Vorrichtung nach Anspruch 1, **dadurch gekennzeichnet, dass** der Kollektor (10) bestimmt ist zum Erwärmen des Formgedächtniselementes (13) durch direktes Fokussieren der Sonneneinstrahlung über die Linsen (12), die oben auf dem Formgedächtniselement (13) eingerichtet sind, oder andernfalls durch Fokussieren der direkten Einstrahlung der Sonne auf die Innenwand des Kollektors (10), die als ein Schwarzkörper wirkt, der ausgelegt ist, um seine Innentemperatur zu erhöhen.

12. Aktorvorrichtung nach Anspruch 1, **dadurch gekennzeichnet, dass** der Kollektor (10) bestimmt ist zum Erwärmen des Formgedächtniselementes (13) über die Linsen (12), die die direkte Einstrahlung der Sonne auf einen Teil der Innenfläche des Kollektors richten, wobei die Fläche reflektierend und auf das Formgedächtniselement (13) fokussierend ist.

## Revendications

1. Dispositif formant actionneur à mémoire de forme pour imprimer un mouvement de poursuite solaire sur un élément orientable (2), qui est rotatif autour d'un axe d'articulation (4), ledit dispositif comprenant au moins un élément à mémoire de forme (13) activé par la chaleur générée par le rayonnement solaire,
dans lequel l'élément à mémoire de forme (13) est entouré par une distribution de lentilles (12) conçues pour toujours focaliser, au fur et à mesure que la position du soleil varie, le rayonnement solaire direct sur l'élément à mémoire de forme (13), ledit dispositif comprenant en outre un élément pare-soleil (14), relié en rotation à l'élément orientable (2) et commandé par l'élément à mémoire de forme (13) de telle manière qu'il est déplacé, suite à l'activation de l'élément à mémoire de forme (13) en raison du rayonnement solaire, jusqu'à une position dans laquelle il protège l'élément à mémoire de forme par rapport au rayonnement solaire direct, avec la désactivation consécutive de l'élément à mémoire de forme (13) et un retour de l'élément de protection (14) dans une position dans laquelle il découvre à nouveau l'élément à mémoire de forme (13) par rapport au rayonnement solaire direct, déterminant ainsi la réactivation de l'élément pare-soleil, avec pour résultat une oscillation continue de l'élément pare-soleil (14) autour d'une position qui correspond à un alignement souhaité de l'élément orientable sur le soleil et qui suit le soleil dans sa trajectoire,
**caractérisé en ce que** la distribution susmentionnée de lentilles (12) est définie sur un secteur angulaire (A) de la paroi d'un collecteur cylindrique (10) concentrique par rapport audit axe d'articulation (4), et **en ce que** l'élément à mémoire de forme (13) est défini à l'intérieur dudit collecteur cylindrique, et
**en ce que** l'élément pare-soleil (14) comprend une paroi cylindrique qui est concentrique par rapport à la paroi cylindrique du collecteur (10).

2. Dispositif formant actionneur selon la revendication 1, **caractérisé en ce que** des moyens (15) sont prévus pour rappeler l'élément pare-soleil (14) vers une position de fin de course.

3. Dispositif formant actionneur selon la revendication 2, **caractérisé en ce que** lesdits moyens sont constitués d'un ressort (15).

4. Dispositif formant actionneur selon la revendication 1, **caractérisé en ce que** l'élément à mémoire de forme (13) est sous la forme d'une barre de torsion, avec une extrémité (13a) ancrée sur le corps du collecteur (10) et l'extrémité opposée (13b) reliée en rotation à l'élément pare-soleil (14) susmentionné.

5. Dispositif formant actionneur selon la revendication 1, **caractérisé en ce que** ladite paroi cylindrique de l'élément pare-soleil (14) est définie à l'intérieur de la paroi cylindrique du collecteur (10).

6. Dispositif formant actionneur selon la revendication 5, **caractérisé en ce que** le corps du collecteur (10) est fixé à un châssis (3), sur lequel l'élément orientable (2) susmentionné est monté en rotation et **en ce que** ledit élément pare-soleil (14) est relié en rotation audit élément orientable (2).

7. Dispositif formant actionneur selon l'une quelconque des revendications précédentes, **caractérisé en ce que** ledit élément orientable est constitué d'un module photovoltaïque (2) comprenant une paroi allongée (6) ayant ses extrémités opposées supportées d'une manière articulée sur un châssis (3) et portant une distribution alignée de cellules photovoltaïques (5), ladite plaque allongée (6) supportant à son tour une structure de couverture comprenant une distribution de lentilles de focalisation (8), chacune étant associée à une cellule photovoltaïque (5) pour concentrer sur cette dernière le rayonnement solaire, l'agencement étant tel que le dispositif formant actionneur susmentionné maintient de façon constante l'élément pare-soleil (14) dans une position qui correspond à une position de la plaque (6) susmentionnée portant les cellules photovoltaïques (5) de façon orthogonale au rayonnement direct (R) du soleil.

8. Dispositif formant actionneur selon la revendication 1, **caractérisé en ce que** la paroi du collecteur présente des ouvertures contrôlées par trappes, qui peuvent s'ouvrir automatiquement pour mettre en communication l'environnement interne du collecteur et l'environnement externe lorsque la température à l'intérieur du collecteur dépasse une valeur prédéfinie.

9. Dispositif formant actionneur selon la revendication 8, **caractérisé en ce que** lesdites trappes sont commandées par des moyens formant actionneur à mémoire de forme sensibles à la température à l'intérieur du collecteur.

10. Dispositif formant actionneur selon la revendication 1, **caractérisé en ce que** ledit élément actionneur à mémoire de forme (13) est constitué d'un élément allongé, dont la longueur diminue lorsqu'une température de transition est dépassée, et **en ce qu'**une transmission mécanique est prévue pour convertir le mouvement linéaire de l'élément à mémoire de forme en un mouvement rotatif de l'élément pare-soleil susmentionné.

11. Dispositif selon la revendication 1, **caractérisé en ce que** le collecteur susmentionné (10) est préconçu pour chauffer l'élément à mémoire de forme (13) en focalisant directement le rayonnement solaire via lesdites lentilles (12) placées au-dessus de l'élément à mémoire de forme (13), ou bien en focalisant le rayonnement direct du soleil sur la paroi interne du collecteur (10), qui fonctionne comme un corps noir conçu pour augmenter sa température interne.

12. Dispositif selon la revendication 1, **caractérisé en ce que** le collecteur (10) susmentionné est préconçu pour chauffer l'élément à mémoire de forme (13) via lesdites lentilles (12), en dirigeant le rayonnement direct du soleil sur une partie de la surface interne du collecteur, ladite surface étant réflective et assurant la focalisation sur l'élément à mémoire de forme (13).
